# EUROPÄISCHE PATENTSCHRIFT

(11) **EP 4 014 097 B1**
(45) Veröffentlichungstag und Bekanntmachung des Hinweises auf die Patenterteilung: **18.06.2025**
(21) Anmeldenummer: 20753299.5
(22) Anmeldetag: 28.07.2020
(51) Int. Cl.: G05B 19/4099, G05B 19/42, B33Y 50/02, B23K 26/342, B23K 26/03, B23K 26/144, B22F 10/25, B22F 10/366, B23P 6/00, B22F 7/06

(54) **VORRICHTUNG UND VERFAHREN ZUR REPARATUR VON BAUTEILEN MITTELS ADDITIVER FERTIGUNG**
DEVICE AND METHOD FOR REPAIRING COMPONENTS BY MEANS OF ADDITIVE MANUFACTURING
DISPOSITIF ET PROCÉDÉ DE RÉPARATION DE COMPOSANTS PAR FABRICATION ADDITIVE

(30) Priorität: 14.08.2019 DE 102019121947
(43) Veröffentlichungstag der Anmeldung: 22.06.2022
(73) Patentinhaber: DMG MORI Ultrasonic Lasertec GmbH, 55758 Stipshausen (DE)
(72) Erfinder: ALBERT, David, 87677 Stöttwang OT Thalhofen (DE); DIEDERICH, Patrick, 71272 Renningen (DE); REISACHER, Martin, 87435 Kempten (DE)
(74) Vertreter: MERH-IP Matias Erny Reichl Hoffmann Patentanwälte PartG mbB
(86) Internationale Anmeldenummer: PCT/EP2020/071274
(87) Internationale Veröffentlichungsnummer: WO 2021/028216

(56) Entgegenhaltungen:
- EP-A1- 3 482 853
- CN-A- 108 340 582
- CN-A- 108 489 986
- CN-A- 109 676 135
- US-A1- 2018 141 123
- JIAN GAO ET AL: "An integrated adaptive repair solution for complex aerospace components through geometry reconstruction", THE INTERNATIONAL JOURNAL OF ADVANCED MANUFACTURING TECHNOLOGY, SPRINGER, BERLIN, DE, vol. 36, no. 11-12, 3 February 2007 (2007-02-03), pages 1170 - 1179, XP019583787, ISSN: 1433-3015

## Beschreibung

Die vorliegende Erfindung bezieht sich auf eine Vorrichtung und ein Verfahren zur Reparatur von Bauteilen mittels additiver Fertigung und insbesondere zur Reparatur von Vertiefungen in Bauteilen.

### Hintergrund der Erfindung

Für die Reparatur von Schäden an Bauteilen wird üblicherweise in einem ersten Schritt eine Ausfräsung der Reparaturstelle vorgenommen. In einem weiteren Schritt wird die ausgefräste Stelle gescannt und ein entsprechendes Computermodell erstellt. Basierend auf diesen Daten wird wiederum ein Strukturmodell erstellt, welches in die Ausfräsung eingesetzt werden kann, um die Schadstelle zu reparieren. Durch einen solchen Reparaturprozess ist es möglich, eine Schadstelle an der Oberfläche eines Bauteils auszubessern, so dass wiederum die ursprüngliche Oberfläche hergestellt werden kann. Die einzusetzende Struktur kann über additive Fertigungsverfahren hergestellt werden und in die Ausfräsung eingebracht werden.

Ein Reparaturverfahren ist beispielsweise aus der US 2017/0370221 A1 bekannt. In diesem Verfahren muss in einem ersten Schritt die Fehlstelle von einem zu reparierenden Bauteil entfernt werden. Über ein additives Fertigungsverfahren kann eine reparierte Komponente erstellt werden, so dass das Bauteil wiederum die ursprüngliche Geometrie erhalten kann. Bekannte Verfahren haben jedoch den Nachteil, dass mehrere Datenkonvertierungsschritte und Verarbeitungsschritte der Messdaten nötig sind, um aus den Messdaten des zu reparierenden Bauteils eine Struktur zu erstellen, welche dann mit dem additiven Fertigungsverfahren hergestellt werden kann. Somit wird meist eine Aufbereitung der Daten nötig. Es resultiert somit ein hoher Rechenaufwand und ein hoher Datenaufwand.

Darüber hinaus ist in der CN 108 340 582 A ein automatisiertes Reparaturverfahren beschrieben, welches mittels Aufnahme von thermischen Infrarotbildern, etwaige Fehlstellen innerhalb des zu reparierenden Bauteils identifizieren und den daraufhin durchzuführenden Reparaturprozess an die identifizierten Fehlstellen anpassen kann.

Zudem wird auch in der CN 109 676 135 A ein auf einer vorherigen Bildgebung basierender Bearbeitungsprozess vorgestellt, in welchem mithilfe von Grauwert-Bildanalysen, ein Feedback-Reparatur-System generiert wird. Genauer sieht das oben genannte Verfahren vor, zunächst mittels Vergleich von aufgenommenen Bildintensitätsdaten mit vordefinierten Schwellenwerten, bestehende Defekte innerhalb des zu untersuchenden Bauteils zu finden. In einem darauffolgenden Prozess werden zudem die erstellten Informationen an eine Auswerteeinheit weitergegeben, um so einen speziell auf den Defekt angepassten Reparaturprozess zu ermöglichen.

Ferner ist in der CN 108 489 986 A ein auf Umschmelzung von Bauteilen basierendes Reparatursystem gezeigt, bei welchem zunächst mittels Positionierung eines aus zwei CCD-Kameras bestehenden Aufnahmemoduls, dreidimensionale Schnittzeichnungen von einem zu bearbeitenden Bauteil generiert und diese zur Analyse an einen externen Computer weitergeleitet werden. Darüber hinaus ist besagter Computer konfiguriert, mittels implementierter Bildanalyseprogramme, bestehende Defekte innerhalb des Bauteils zu detektieren und an ein additives Fertigungsgerät samt Laservorrichtung zu vermitteln, sodass ein iterativer Detektions- und Bearbeitungsmechanismus generiert werden kann.

Ausgehend von dem vorgenannten Stand der Technik ist es eine Aufgabe der vorliegenden Erfindung die beschriebenen Probleme zu lösen. Insbesondere ist es eine Aufgabe ein effizientes Verfahren zur Reparatur von Bauteilen mittels additiver Fertigung bereitzustellen sowie eine entsprechende Vorrichtung.

### Zusammenfassung der Erfindung

Zur Lösung der vorstehend genannten Aufgaben der vorliegenden Erfindung werden die Merkmale der unabhängigen Ansprüche vorgeschlagen und bevorzugte Weiterbildungen sind in den abhängigen Ansprüchen.

Gemäß der vorliegenden Erfindung kann ein Verfahren zur automatisierten Reparatur von Bauteilen mit einem additiven Fertigungssystem einen ersten Schritt umfassen, in dem das schadhafte Bauteil in das Fertigungssystem eingespannt wird. In einem weiteren Schritt kann ein Reparaturbereich festgelegt werden, der die zu reparierende Fläche des Bauteils umfasst. Zudem kann ein Werkzeugpfad innerhalb des Reparaturbereichs festgelegt werden. Der Werkzeugpfad entspricht dem Verfahrweg, den das Werkzeug des Fertigungssystems in einem Zyklus abfährt. In einem weiteren Schritt kann die Beschaffenheit des Bauteils im Reparaturbereich ermittelt werden (= Messzyklus). In einem solchen Messzyklus können Datenwerte bestimmt werden entlang des festgelegten Werkzeugpfads. Die Datenwerte entsprechen der Abweichung der Fläche des Bauteils von einem vorgegebenen Abmaß. Insbesondere kann die ermittelte Abweichung die Tiefe (bzw. der Betrag davon) der Schadstelle an einem Punkt (Messpunkt) sein. In einem weiteren Schritt kann ein selektives Aufbringen von Füllstoff bzw. Füllmaterial durchgeführt werden. Der Füllstoff kann entlang des festgesetzten Werkzeugpfades in zumindest einem Füllzyklus aufgebracht werden. In einem Füllzyklus kann ein Teil oder bevorzugt der gesamte Werkzeugpfad abgefahren werden und dabei kann selektiv das Fertigungssystem zum Aufbringen des Füllstoffs aktiviert werden in Abhängigkeit von der Differenz zwischen dem Datenwert am Pfad und einem vorbestimmten Schwellenwert. Durch dieses vorteilhafte Verfahren ist es möglich, die Daten, welche direkt aus dem Messzyklus resultieren, als direkten Input für den Füllzyklus zu verwenden. Im Messzyklus entsteht somit ein Daten-Array mit Messwerten für verschiedene Pfadpunkte (Messpunkte). Dieses Daten-Array ist wiederum der Input für den Füllzyklus und bestimmt nach einem Vergleich mit einem vorbestimmen Schwellenwert das Aktivieren oder Deaktivieren des Fertigungssystems zum Aufbringen des Füllstoffs.

Mit anderen Worten fährt das Fertigungssystem im Füllzyklus den festgelegten Werkzeugpfad ab, entlang der Pfadpunkte. Für jeden der Pfadpunkte kann ein Datenwert ermittelt worden sein, welcher mit dem Schwellenwert verglichen wird. Bei Erreichen eines Pfadpunktes wird der Werkzeugkopf, beispielsweise Laser, des additiven Fertigungssystems aktiviert und ein Material kann aufgebracht werden. Bei Erreichen des nächsten Pfadpunktes wiederum wird ein Vergleich durchgeführt, um festzustellen, ob ein Deaktivieren des Werkzeugkopfs stattfindet, oder ob dieser aktiviert bleibt. Vorteilhaft ist es somit möglich, direkt im Messzyklus das Programm für den Füllzyklus zu erstellen, so dass eine weitere Datenkonvertierung nicht nötig ist und die Datenwerte direkt für die Aktivierung bzw. Deaktivierung des Werkzeugs des Fertigungssystems herangezogen werden. Dadurch, dass der Werkzeugpfad sowohl im Messzyklus als auch im Füllzyklus identisch sein kann, kann der Rechenaufwand und der Datenaufwand weiter reduziert werden. Zudem können der Messzyklus und der Füllzyklus automatisch durchgeführt werden, so dass eine im Wesentlichen automatische Reparatur des Bauteils ermöglicht wird. Aufwändige und fehleranfällige Datenumwandlungen von Punktwolken der Messwerte, welche sich aus der Vermessung der Schadstelle des Bauteils ergeben können, sind nicht nötig. Besonders vorteilhaft wird somit ein vereinfachtes Verfahren zur Reparatur von Bauteilen mittels additiver Fertigung erreicht, welches zugleich eine geringere Störanfälligkeit aufweist.

Der Werkzeugpfad kann eine Vielzahl von Pfadpunkten aufweisen. Im Messzyklus kann eine Abweichung in eine Werkzeugrichtung (beispielsweise eine Z-Richtung) zwischen der Oberfläche des Bauteils und einer gewünschten Form an jedem der Pfadpunkte ermittelt werden. Die Werkzeugrichtung kann beispielsweise die Richtung sein, welche orthogonal zur Bauteiloberfläche im Reparaturbereich ist.

Vorteilhaft können die Datenwerte die Abweichung der Bauteiloberfläche in der Werkzeugrichtung angeben und die Werkzeugrichtung kann orthogonal zur Werkstückoberfläche (beispielsweise eine XY-Ebene) sein, auf der der Werkzeugpfad liegt. Das Werkzeug des additiven Fertigungssystems, wie beispielsweise ein Laser, wird somit auf der Werkstückoberfläche verfahren, entlang des Werkzeugpfads. Dieser Werkzeugpfad bzw. die Werkstückoberfläche kann bspw. orthogonal zur Werkzeugrichtung sein, welche die Abweichung bestimmt.

In einem Füllzyklus kann der Füllstoff entlang eines Pfadsegments des festgelegten Werkzeugpfads selektiv aufgebracht werden. Der Füllstoff kann somit während dem Verfahren von einem Pfadpunkt zum benachbarten Pfadpunkt aufgebracht werden. Ein Ausschalten des Werkzeugs des Fertigungssystems zum Aufbringen des Füllstoffs wird am Zielpfadpunkt in Abhängigkeit von der Differenz zwischen dem Datenwert am Zielpfadpunkt und dem vorbestimmten Schwellenwert ermittelt. Fährt beispielsweise das Werkzeug entlang dem Werkzeugpfad von einem Pfadpunkt zum nächsten und wird dabei stets der Schwellenwert überschritten, so kann beispielsweise der Laser ständig aktiviert sein, so dass ein Aufbringen des Füllstoffs stets durchgeführt wird. Als additive Fertigung kann beispielsweise Pulverdüsenauftragschweißen vorgesehen sein. Wird während dem Verfahren ein Pfadpunkt erreicht, an dem der Datenwert geringer als der Schwellenwert ist, so kann ein Ausschalten des Lasers bzw. des Werkzeugkopfes bewirkt werden. Erst bei Erreichen eines weiteren Pfadpunktes, bei dem der zugehörige Datenwert wiederum den Schwellenwert überschreitet, wird wiederum der Laser aktiviert.

Ein Pfadsegment kann von zwei Pfadpunkten begrenzt sein und das Pfadsegment kann bevorzugt geradlinig verlaufen. Durch diese besonders effiziente und einfache Ausgestaltung der Pfadsegmente, welche zusammengesetzt den Werkzeugpfad bilden, kann eine weitere Vereinfachung des Reparaturverfahrens erreicht werden, da insbesondere gekrümmte Segmente vermieden werden und nur ein Verfahren in einer X-Richtung und in einer Y-Richtung nötig ist. Bevorzugt können die Datenwerte auch gemittelte Werte von Pfadpunkten eines Segments sein. Ein Aktivieren des Werkzeugs kann somit auch segmentweise durchgeführt werden.

Der Schwellenwert kann in einem Füllzyklus konstant sein. In einem Füllzyklus kann somit das Werkzeug des Fertigungssystems entlang des festgelegten Werkzeugpfads den gesamten Reparaturbereich abfahren, wobei jeder der Datenpunkte mit dem Schwellenwert des Füllzyklus verglichen wird. Nach dem Abschluss des Füllzyklus kann ein weiterer Füllzyklus vorgesehen sein mit einem abgeänderten Schwellenwert. Durch diese Konfiguration der Füllzyklen ist es möglich eine sukzessive Reparatur der Fehlstellen zu ermöglichen. In jeden Füllzyklus ist somit eine Ebene, welche orthogonal zur Werkzeugrichtung ist, definiert. Jede dieser Ebenen hat wiederum einen unterschiedlichen Schwellenwert bis letztlich bei der letzten Ebene ein minimaler Schwellenwert vorliegt, so dass eine finale Oberfläche (bspw. eine plane Oberfläche) des Bauteils im Reparaturbereich erreicht werden kann. Besonders vorteilhaft kann ein zusätzliches Aufmaß nach Erreichen des minimalen Schwellenwertes aufgetragen werden. Beispielsweise kann somit nach Erreichen des minimalen Schwellenwertes in einem (oder mehreren) zusätzlichen Füllzyklus der gesamte Reparaturbereich mit Füllstoff beaufschlagt werden.

Es können mehrere Füllzyklen durchgeführt werden und der Schwellenwert kann jeweils um einen Dickenwert angepasst werden, bis eine im Wesentlichen gleichmäßige Oberfläche im Reparaturbereich vorliegt. Im Reparaturbereich kann somit die ursprüngliche Oberflächenform (bspw. linear oder gekrümmt) des Bauteils wiederhergestellt werden. Der Dickenwert kann beispielsweise abhängig von einer Höhe des Materials sein, welches im Füllzyklus aufgebracht wird.

Das Ergebnis des Messzyklus kann ein Array sein, aus den ermittelten Datenwerten. Der Schwellenwert kann für den ersten Füllzyklus basierend auf einem Maximalwert oder einem Minimalwert (Extremwert) des Arrays und einer Konstanten festgelegt werden. Insbesondere wird der Maximalwert des Arrays verwendet, um die tiefste Fehlstelle des Reparaturbereichs zu ermitteln. Abhängig von dieser tiefsten Stelle, kann der Schwellenwert festgelegt werden, so dass im ersten Füllzyklus lediglich ein Auffüllen der tiefsten Schadstellen erreicht wird. Im darauffolgenden Füllzyklus wird wiederum ein reduzierter Schwellenwert verwendet, so dass zusätzliche Bereiche mit Füllmaterial aufgefüllt werden können. Sukzessive durch die Aneinanderreihung der Füllzyklen wird somit ein komplettes Auffüllen der Schadstellen erreicht.

Der Schwellenwert kann in einem weiteren Füllzyklus um einen Dickenwert reduziert sein, wobei der Dickenwert der Höhe des aufgebrachten Füllstoffs in einem Füllzyklus entspricht, insbesondere an einem Pfadpunkt oder Pfadsegment. Eine solche Höhe ist beispielsweise die Höhe der Schweißnaht.

Die ermittelten Datenwerte des Messzyklus können direkt für den Füllzyklus verwendet werden. Somit ist ein Konvertieren oder Umwandeln bzw. Digitalisieren der Ergebnisse des Messzyklus nicht nötig. Ein besonders effizientes und einfaches Reparaturverfahren kann somit bereitgestellt werden. Zudem wird die Fehlerhäufigkeit, welche meist aufgrund von Konvertierungsfehlern entstehen können, vermieden.

Datenwerte können (ohne Datenkonvertierung) zum Vergleich mit dem Schwellenwert im Füllzyklus verwendet werden. Somit werden die unkonvertierten Datenwerte aus dem Messzyklus direkt verwendet, um im Vergleich mit dem Schwellenwert an den jeweiligen Pfadpunkten zu entscheiden, ob das Werkzeug des adaptiven Fertigungssystems aktiviert wird oder deaktiviert wird (d.h. ob Material eingetragen wird).

Das Verfahren kann vorteilhaft somit ein Verfahren zur Erstellung einer planen und/oder gekrümmten Oberfläche in einem Reparaturbereich sein. Die reparierte Oberflächenform entspricht vorteilhaft einer ursprünglichen Oberflächenform des Bauteils.

Der Werkzeugpfad kann vorteilhaft unter Berücksichtigung eines Arbeitsdurchmessers des Fertigungssystems festgelegt werden. Ein solcher Arbeitsdurchmesser des adaptiven Fertigungssystems kann beispielsweise der Durchmesser des Lasers sein (beim Pulverdüsenauftragschweißen). Unter Berücksichtigung dieses Arbeitsdurchmessers kann der Werkzeugpfad vorteilhaft derart festgelegt werden, dass der gesamte Reparaturbereich vollständig abgedeckt werden kann.

Der Werkzeugpfad kann ein nicht überlappender, durchgehender Linienzug sein. Weiter bevorzugt kann der Werkzeugpfad mäanderförmig ausgestaltet sein. Der Werkzeugpfad kann zudem aus Liniensegmenten bestehen, welche jeweils geradlinig verlaufen. Somit kann ein besonders fehlerunanfälliges Verfahren bereitgestellt werden mit einem optimierten Werkzeugpfad. Zudem kann der Werkzeugpfad konturparallel zum Reparaturbereich ausgestaltet sein.

Der Reparaturbereich kann festgelegt werden, so dass die zu reparierende Fläche des Bauteils vollständig abgedeckt werden kann. Somit kann erreicht werden, dass durch das Verfahren eine plane Oberfläche (oder vorteilhaft auch eine gekrümmte Oberfläche gem. der ursprünglichen Bauteilform) an der Reparaturstelle erzeugt werden kann.

Vorteilhaft kann in einem finalen Füllzyklus das Werkzeug des additiven Fertigungssystems beim Abfahren des festgelegten Werkzeugpfades durchgehend aktiviert sein. Durch diese Vorgehensweise ist es möglich, sämtliche möglicherweise verbleibenden Unebenheiten auszugleichen. Zudem kann dadurch ein Aufmaß über die gesamte Fläche des Reparaturbereichs bereitgestellt werden.

Der festgelegte Werkzeugpfad ist vorteilhaft der Verfahrensweg des Werkzeugs des additiven Fertigungssystems und gleichzeitig der Verfahrensweg des Messinstruments für die Bestimmung der Abweichung. Ein Konvertieren des Verfahrenswegs bzw. des Werkzeugpfads ist somit zwischen dem Messzyklus und dem Füllzyklus bzw. sämtlichen Füllzyklen nicht notwendig. Somit kann der Rechenaufwand weiter reduziert werden und die Fehleranfälligkeit auf ein Minimum reduziert werden.

Das Werkzeug des additiven Fertigungssystems kann entlang des festgelegten Werkzeugpfades von einem Pfadpunkt zu einem benachbarten Pfadpunkt verfahren werden, wobei an jedem Pfadpunkt ein Vergleich des ermittelten Datenwerts des jeweiligen Pfadpunkts mit einem Schwellenwert durchgeführt werden kann und bei Überschreiten des Schwellenwerts kann das Werkzeug aktiviert werden. Beim Unterschreiten des Schwellenwerts wiederum kann das Werkzeug deaktiviert werden (oder umgekehrt, bei umgekehrten Vorzeichen). Vorteilhaft ist es somit möglich durch die Messwerte an den Pfadpunkten direkt ein Befehls-Array bereitzustellen, welches den Laser bzw. das Werkzeug des additiven Fertigungssystems aktiviert oder deaktiviert.

Besonders vorteilhaft wird der Messzyklus und der anschließende Füllzyklus automatisch durchgeführt und ein manuelles Einschreiten wird somit nicht benötigt. Weiter vorteilhaft wird der Messzyklus und sämtliche darauffolgenden Füllzyklen automatisch durchgeführt. Die Datenwerte sind somit für alle Füllzyklen gleich. Alternativ kann nach den einzelnen Füllzyklen vorteilhaft jeweils ein weiterer Messzyklus vorgesehen sein, für eine verbesserte Genauigkeit.

Das Verfahren kann ein Verfahren zum Auffüllen von Vertiefungen einer Bauteiloberfläche in einem Schadbereich sein.

Das Verfahren kann vorteilhaft den Schritt umfassen, Bewegen des Werkzeugs entlang von Pfadpunkten des festgelegten Werkzeugpfads, wobei bei Erreichen eines Pfadpunktes, an dem der Datenwert größer als der Schwellenwert ist, ein Laser aktiviert wird und bei Erreichen eines Pfadpunktes, an dem der Datenwert nicht größer als der Schwellenwert ist, der Laser deaktiviert wird. Es können eine Vielzahl von Füllzyklen vorgesehen werden, wobei der Schwellenwert sich von Füllzyklus zu Füllzyklus reduzieren kann. Vorteilhaft wird der Schwellenwert für den finalen Füllzyklus derart reduziert, dass sämtliche Datenwerte jeglicher Datenpunkte größer als der Schwellenwert sind. Besonders vorteilhaft kann der Schwellenwert derart eingestellt werden, dass mehrere Schichten Aufmaß im Reparaturbereich aufgetragen werden.

Der festgelegte Werkzeugpfad kann vorteilhaft parallele Segmente umfassen und der Abstand zwischen benachbarten Segmenten kann abhängig vom Arbeitsdurchmesser des Lasers festgelegt werden.

Das additive Fertigungssystem kann einen Laser umfassen, wobei ein Einschalten und Ausschalten des Lasers an Pfadpunkten in Abhängigkeit vom Ergebnis des Vergleichs zwischen Datenwert am Pfadpunkt und Schwellenwert ist.

Für den Messzyklus (zur Bestimmung der Datenwerte) kann vorteilhaft ein Messtaster oder ein optischer Sensor verwendet werden. Zudem kann ein kapazitiver und/oder induktiver Sensor für die Bestimmung verwendet werden.

Vorteilhaft kann eine Vorrichtung zur Datenverarbeitung vorgesehen sein zur Ausführung des oben genannten Verfahrens. Zudem kann ein computerlesbares Speichermedium vorgesehen sein, welches Befehle umfasst, die bei der Ausführung durch einen Computer diesen veranlassen, das oben genannte Verfahren auszuführen. Es kann ein additives Fertigungssystem vorgesehen sein, welches zum Ausführen des oben genannten Verfahrens konfiguriert ist und dazu eine entsprechende Recheneinheit aufweist.

Im Folgenden wird die Erfindung anhand von Beispielen in Bezug auf die beiliegenden Figuren beschrieben.

### Figuren

- Fig. 1:: zeigt eine Übersicht über eine zu reparierende Fläche mit einem eingezeichneten Werkzeugpfad PF;
- Fig. 2:: zeigt eine Detailansicht des Werkzeugpfades PF;
- Fig. 3a:: zeigt eine erste Ansicht in einem Füllzyklus;
- Fig. 3b:: zeigt eine weitere Ansicht in einem Füllzyklus;
- Fig. 3c:: zeigt eine weitere Ansicht des Werkzeugpfades im Füllzyklus;
- Fig. 3d:: zeigt eine Ansicht eines weit fortgeschrittenen Füllzyklus;
- Fig. 3e:: zeigt einen finalen Füllzyklus;
- Fig. 4:: zeigt eine Detailansicht des Werkzeugpfades im Füllzyklus;

### Detaillierte Beschreibung

Die folgenden Merkmale der Ausführungsbeispiele sind im Ganzen oder teilweise kombinierbar und die vorliegende Erfindung ist in keiner Weise auf die beschriebenen Ausführungsbeispiele beschränkt. In den Zeichnungen werden gleiche bzw. ähnliche Merkmale mit gleichen Bezugszeichen gekennzeichnet.

Die vorliegende Erfindung betrifft ein optimiertes Verfahren zur automatisierten Reparatur von Bauteilen, welche beispielsweise Schäden aufweisen. Solche Schäden können Ausbuchtungen, Kratzer, Riefen, etc. sein. Um die Vertiefung im Bauteil zu reparieren, wird ein Verfahren vorgeschlagen, bei dem der Rechenaufwand auf ein Minimalmaß reduziert werden kann. Die Datenverarbeitung kann somit auf ein Mindestmaß reduziert werden, so dass gleichzeitig auch die üblicherweise häufig auftretenden Konvertierungsfehler vermieden werden können. Ein zusätzliches Aufbereiten der Messdaten, um daraus ein Modell (bspw. CAD-Modell) zu erstellen, welches für die Reparatur verwendet werden kann, ist nicht nötig, da gemäß der vorliegenden Erfindung direkt die Daten aus dem Messzyklus als Input für einen Füllzyklus verwendet werden. In einem solchen Füllzyklus wird schichtweise Material auf das Bauteil aufgetragen mittels additiver Fertigung. Die vorliegende Erfindung ist besonders vorteilhaft für additive Fertigungsverfahren einsetzbar, welche laserbasiert arbeiten.

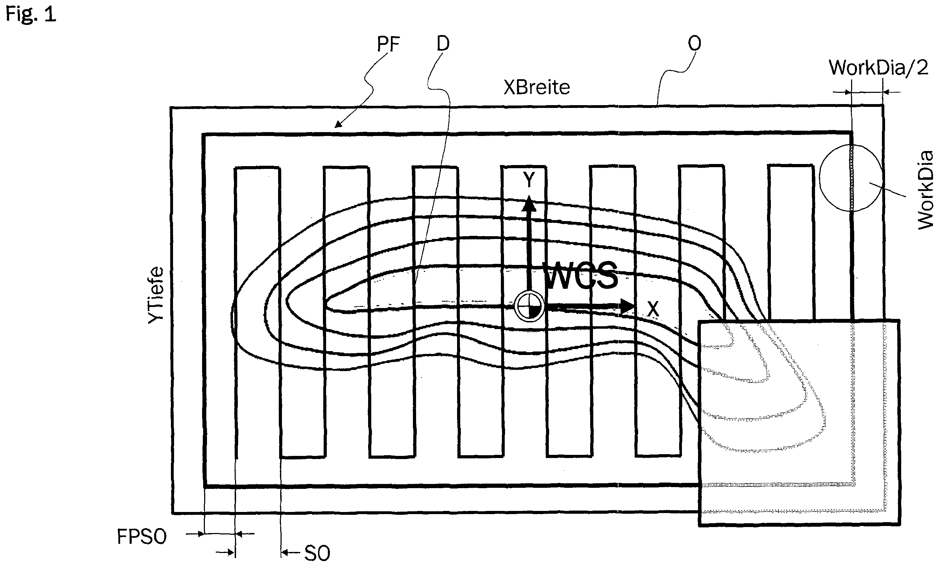

In Fig. 1 ist eine erste Ansicht eines Reparaturbereichs O dargestellt. Der Reparaturbereich O deckt die zu reparierende Fläche des metallischen Bauteils vollständig ab, wobei der Rand des festgelegten Reparaturbereichs O einen Mindestabstand zur reparierenden Fläche aufweisen sollte. Wie in Fig. 1 dargestellt, ist der zu reparierende Schaden D am Bauteil eine Vertiefung. Diese Vertiefung wird mittels des erfindungsgemäßen Verfahrens vollständig aufgefüllt, so dass das Bauteil am Ende des Verfahrens eine plane Oberfläche aufweist.

In Fig. 1 ist ein beispielhafter Werkzeugpfad PF dargestellt. Der Werkzeugpfad PF legt den Weg fest, den das Werkzeug des Fertigungssystems in einem Zyklus abfährt. Der Werkzeugpfad PF ist jedoch nicht auf die in Fig. 1 dargestellte geradlinige Ausgestaltung beschränkt, sondern könnte auch Kurvenstücke umfassen. Vorteilhaft umfasst der Werkzeugpfad PF jedoch ausschließlich geradlinige Abschnitte, so dass der Rechenaufwand weiter reduziert werden kann. Der Werkzeugpfad PF kann vorteilhafterweise auch in Abhängigkeit des Arbeitsdurchmessers (WorkDia) festgelegt werden. Wie in Fig. 1 dargestellt, ist der Durchmesser des Fertigungssystems beispielsweise ein Durchmesser des Lasers. Abhängig vom Durchmesser dieses Lasers wird der Abstand zwischen benachbarten Segmenten des Werkzeugpfades PF festgelegt. Besonders vorteilhaft entspricht der Abstand zwischen zwei benachbarten Liniensegmenten des Werkzeugpfades PF zumindest dem halben Arbeitsdurchmesser zzgl. 5%. Durch diesen besonders vorteilhaften Abstand wurden sehr zuverlässige Reparaturergebnisse festgestellt.

Der in Fig. 1 dargestellte Werkzeugpfad umfasst beispielsweise einen rechteckigen äußeren Werkzeugpfad PF sowie einen mäanderförmigen inneren Werkzeugpfad PF, bei dem der Startpunkt und der Endpunkt gegenüberliegend voneinander angeordnet sind. Der Werkzeugpfad kann ein durchgehender Werkzeugpfad sein oder kann vorteilhaft auch in mehrere beabstandete Werkzeugpfade aufgeteilt sein. Vorteilhaft überlappt sich kein Liniensegment des Werkzeugpfads PF. Der Werkzeugpfad PF ist derart festgelegt, dass unter Berücksichtigung des Arbeitsdurchmessers die gesamte Fläche im Reparaturbereich O abgedeckt wird. Sowohl im Messzyklus als auch im Füllzyklus bleiben der Werkzeugpfad PF unverändert, was den Rechenaufwand und Datenaufwand zusätzlich reduziert. Die in Fig. 1 dargestellte Ansicht zeigt beispielhaft die XY-Ebene welche hier eine plane Ebene ist. Die Abweichungen der Fläche des Bauteils von einem vorgegebenen Abmaß, welche gleichzeitig dann die Datenwerte DW bilden, werden in die Werkzeugrichtung (bspw. eine Z-Richtung) gemessen. Die Werkzeugrichtung ist beispielsweise die Richtung in der das Werkzeug des Fertigungssystems den Füllstoff aufträgt.

Besonders vorteilhaft kann der Werkzeugpfad PF auch ein ununterbrochener Linienverlauf sein, welcher durchgehend von einem Startpunkt bis zu einem Endpunkt verläuft und dabei (stets) geradlinige Liniensegmente umfasst, welche sich bevorzugt nicht überlappen. In einem solchen Fall kann das im Messzyklus erzeugte Array auch direkt für den Füllzyklus verwendet werden, in Korrespondenz zu den Pfadpunkten. In einer Weiterbildung können gekrümmte Liniensegmente verwendet werden. Beispielsweise kann ein Polynomzug als Liniensegment verwendet werden.

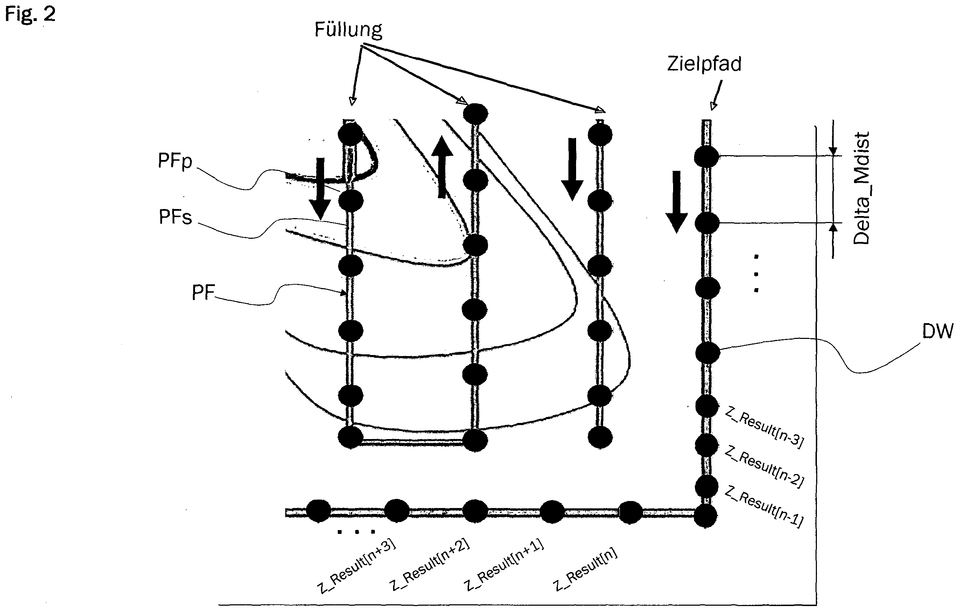

In Fig. 2 ist eine Detailansicht des Reparaturbereichs O dargestellt. Der Werkzeugpfad PF wird dabei gebildet von Pfadpunkten PFp. Diese Pfadpunkte sind aneinandergereiht, wobei zwischen diesen die Pfadsegmente PFs vorliegen. Diese Pfadsegmente PFs sind in diesem Beispiel geradlinige Linienabschnitte. Der Abstand zwischen benachbarten Pfadpunkten PFp kann entlang des Werkzeugpfades variieren, so dass optimale Pfadpunkte PFp vorgesehen sind. Insbesondere können jedoch die Pfadpunkte PFp gleichmäßig über den gesamten Werkzeugpfad PF verteilt werden, wobei zusätzlich in jeder Ecke des Werkzeugpfades PF zumindest ein Pfadpunkt PFp vorgesehen ist, wie dies auch in Fig. 2 dargestellt ist. In einem solchen Eckpunkt kann beispielsweise eine Richtungsänderung des Werkzeugpfades PF vorliegen.

In Fig. 2 sind zudem Pfeile eingezeichnet, welche die Richtung einzeichnen, entlang welcher das Werkzeug des Fertigungssystems, insbesondere der Laser, entlang des Werkzeugpfades PF verfahren wird. Der Werkzeugpfad PF, welcher direkt über der Schadstelle ist, ist bevorzugt ein einzelner, ununterbrochener Werkzeugpfad, welcher in einem Zyklus einmalig entlang einer Richtung durchfahren wird. Beispielsweise kann ein Werkzeugpfad unterbrochen sein, wenn das Werkzeug abgesetzt oder zurückgezogen werden muss (bspw. entlang der Werkzeugrichtung), sodass ein Auftragen von Füllstoff nicht möglich ist. In einer vorteilhaften Weiterentwicklung ist der Werkzeugpfad derart ausgestaltet, dass in einem Füllzyklus lediglich Segmente angefahren werden in denen der Füllstoff aufzutragen ist. In einer solchen Weiterbildung kann sich der Werkzeugpfad im Füllzyklus vom Werkzeugpfad im Messzyklus unterscheiden. Zudem kann sich der Werkzeugpfad von Füllzyklus zu Füllzyklus unterscheiden.

Wie in Fig. 2 dargestellt, sind Datenwerte DW vorgesehen, welche für jeden der Pfadpunkte PFp ermittelt werden.

Das Verfahren zur Reparatur von Bauteilen mittels additiver Fertigung umfasst in einem ersten Schritt das Einspannen des zu reparierenden Bauteils in das Fertigungssystem. Sobald das Bauteil im Fertigungssystem aufgenommen ist, kann ein Reparaturbereich festgelegt werden, der die gesamte (oder nur einen Teil) zu reparierende Fläche des Bauteils abdeckt. Innerhalb dieses Reparaturbereichs, kann dann der Werkzeugpfad PF festgelegt werden. All diese Schritte können als Initialisierungsprozess angesehen werden.

Nach der Initialisierung können bevorzugt vollautomatisch ein Messzyklus und mehrere Füllzyklen folgen. In einem Messzyklus kann das Fertigungssystem automatisch die Tiefenwerte in Z-Richtung (oder allgemein in Werkzeugrichtung) an allen Pfadpunkten PFp des Werkzeugpfades PF ermitteln. Dies ist in Fig. 2 dargestellt mit der Bezeichnung Z_result[n]. Die Datenwerte sind somit beispielsweise die Messwerte in Z-Richtung (oder allgemein in Werkzeugrichtung) an den Pfadpunkten PFp. In einer besonders vorteilhaften Ausgestaltung werden diese Messwerte nacheinander in einem Daten-Array abgespeichert. Das Daten-Array kann somit als eine geordnete Anordnung von gemessenen Tiefenwerten angesehen werden. Die Tiefenwerte können in Relation zu einer vordefinierten Nullebene gemessen werden, welche beispielsweise einer idealen Oberflächentiefe des Bauteils entspricht.

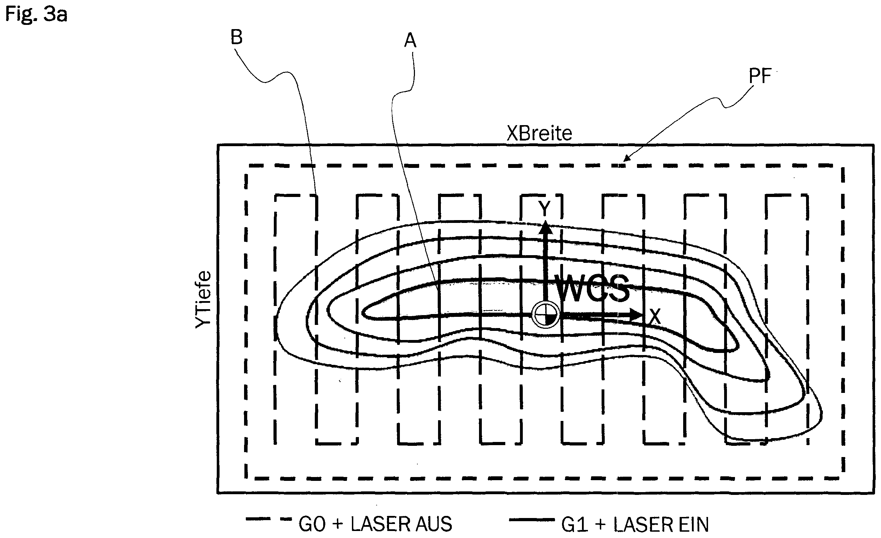

Nachdem die Datenwerte bestimmt sind und ein Daten-Array erstellt ist, kann im direkten Anschluss der erste Füllzyklus folgen, indem über einen additiven Laser selektiv ein Auffüllen der Schadstelle des Bauteils im Reparaturbereich O erfolgt. Solche Füllzyklen sind dargestellt in den Figuren 3a bis 3e. In einem beispielhaften ersten Füllzyklus, wie er in Fig. 3a dargestellt ist, fährt das Werkzeug des additiven Fertigungssystems den gesamten Werkzeugpfad PF ab. Bei jedem erreichten Pfadpunkt PFp wird ein Vergleich des jeweiligen Datenwerts mit dem Schwellenwert durchgeführt. Der Schwellenwert wird festgelegt in Abhängigkeit von der ermittelten Tiefe der Schadstelle. Im ersten Füllzyklus, wie in Fig. 3a dargestellt ist, wird der Maximalwert im Daten-Array ermittelt und der Schwellenwert wird als der Maximalwert angenommen (oder bevorzugt etwas niedriger, um rund 1%). Dies hat zur Folge, dass im ersten Füllzyklus lediglich der Schadensbereich, in dem die maximale Tiefe vorliegt, aufgefüllt wird. Sämtliche Bereiche, in denen die Schadstelle weniger tief ist, werden im ersten Füllzyklus nicht mit Füllstoff aufgefüllt. Dies ist auch in Fig. 3a dargestellt, bei dem der aktivierte Laser A als durchgezogene Linie eingezeichnet ist, entlang des Werkzeugpfades PF. In Bereichen des Werkzeugpfades, in denen der Schwellenwert nicht erreicht oder überschritten wird, ist der Laser deaktiviert B, was in Fig. 3a durch die gestrichelte Linie dargestellt ist. In Fig. 3a wird somit lediglich der innerste Bereich der Schadstelle mit Füllmaterial aufgefüllt.

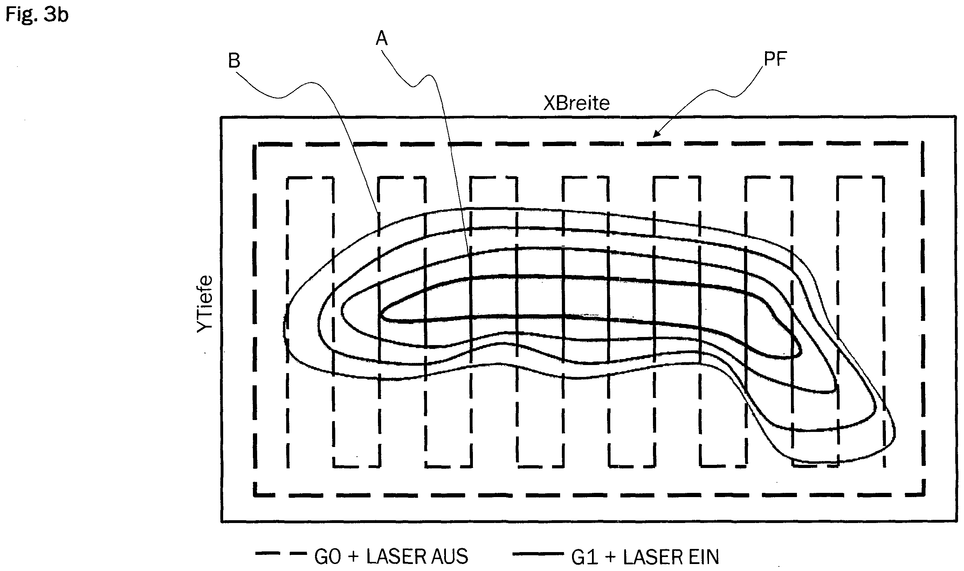

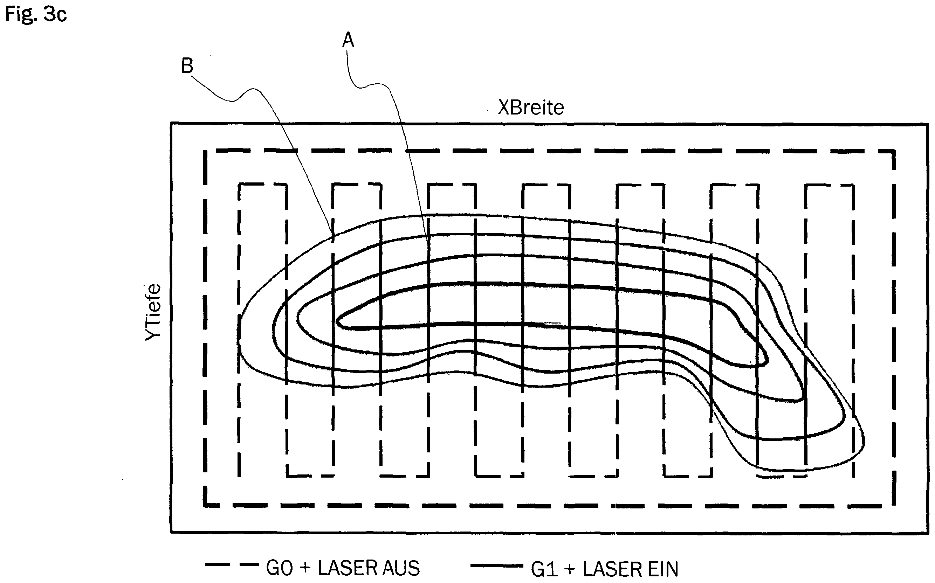

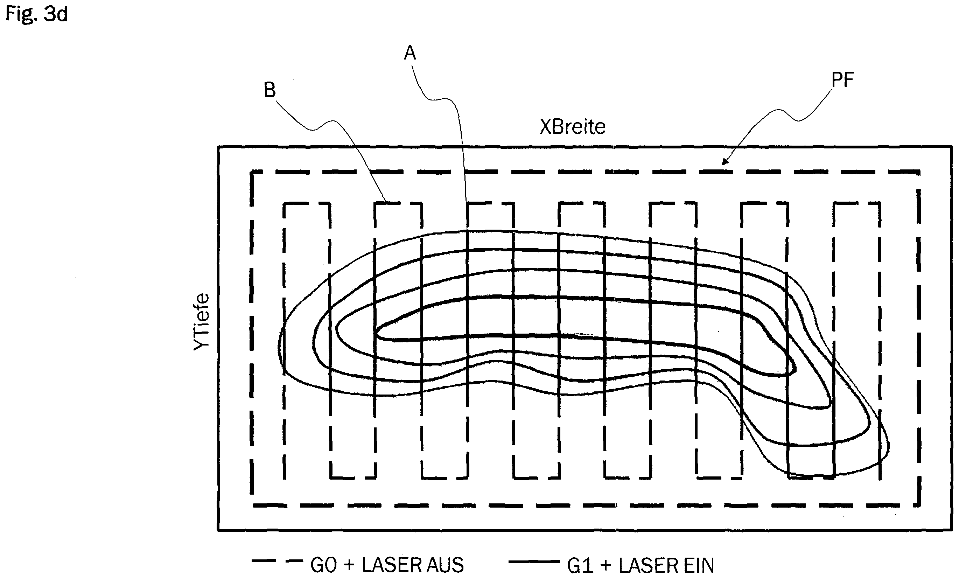

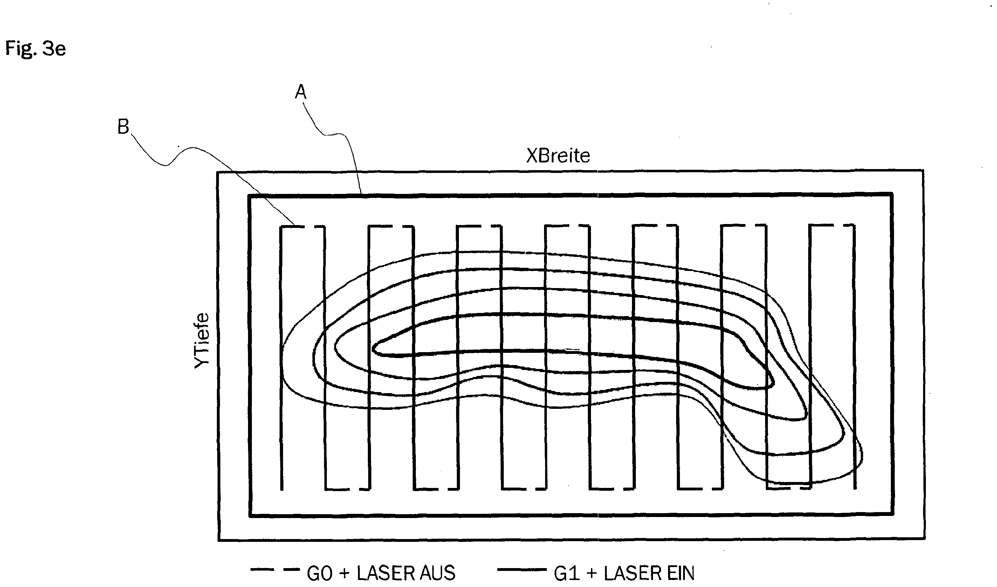

Im darauffolgenden Füllzyklus, wie er in Fig. 3b dargestellt ist, ist der Schwellenwert abgeändert. Insbesondere ist der Schwellenwert reduziert, beispielsweise um die Füllhöhe (bspw. rechnerische Schweißnahtdicke), wie sie im ersten Füllzyklus aufgebracht wurde. Somit, dadurch, dass der Schwellenwert weiter reduziert wurde, ist im in Fig. 3 dargestellten Füllzyklus ein größerer Bereich der Schadstelle mit Füllstoff zu beaufschlagen. Der Laser ist aktiviert A sowohl im Bereich des im ersten Füllzyklus ermittelten Laserbearbeitungsbereichs, als auch den darüber hinausgehenden zusätzlichen Bereich, an dem jeweils der Datenwert der Pfadpunkte die Schwelle überschreitet.

Analog ist in Fig. 3c und 3d jeweils der Füllbereich erhöht und der Laser wird aktiviert A in jeweils größer werdenden Bereichen.

In Fig. 3e ist beispielhaft ein finaler Füllzyklus dargestellt, bei dem der Laser im Wesentlichen durchgehend aktiviert ist A. Lediglich in den horizontalen Abschnitten zwischen zwei benachbarten Liniensegmenten des mäanderförmigen Werkzeugpfades PF ist der Laser deaktiviert B, um die Oberflächengüte weiter zu erhöhen.

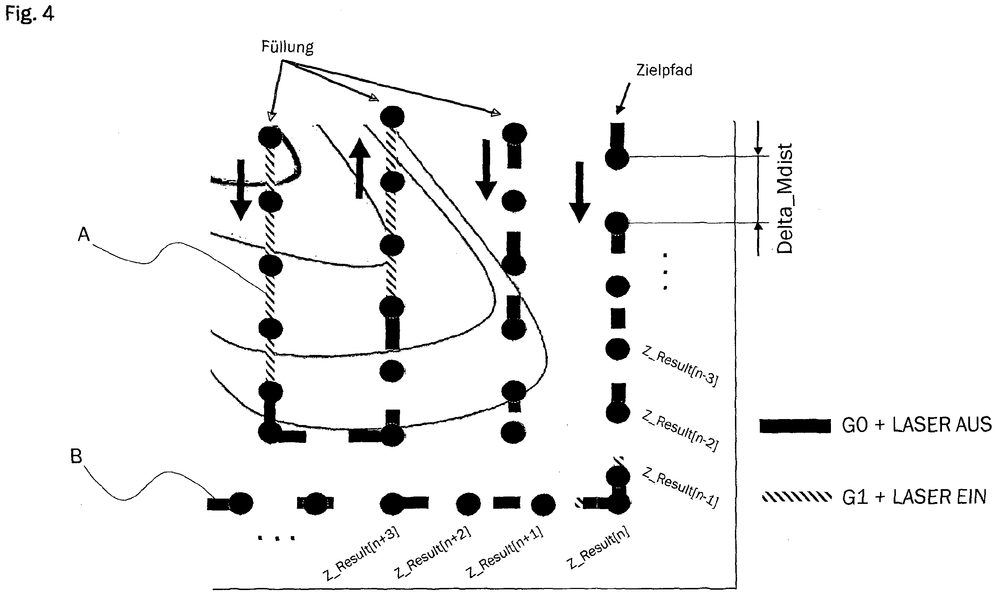

In Fig. 4 ist eine Detailansicht eines Füllzyklus dargestellt. Der Laser ist aktiviert A zwischen zwei benachbarten Pfadpunkten PFp, wenn in Verfahrensrichtung des Lasers ein Pfadpunkt PFp erreicht wird, der den Schwellenwert überschreitet. Erst wenn ein Pfadpunkt PFp erreicht wird, bei dem der Schwellenwert wiederum unterschritten wird, wird der Laser deaktiviert B. Bei sämtlichen Pfadpunkten, bei denen der Datenwert geringer als der Schwellenwert ist, bleibt der Laser deaktiviert bzw. wird deaktiviert, wenn dieser zuvor aktiviert war. Zwar ist im vorliegenden Ausführungsbeispiel das Aktivieren und Deaktivieren des Lasers in Abhängigkeit vom Überschreiten des gemessenen Datenwerts eines Schwellenwerts beschrieben. Es ist jedoch auch möglich, dies mit umgekehrten Vorzeichen durchzuführen. Mit anderen Worten können die Messwerte in Werkzeugrichtung als negative Werte angenommen werden. In einer solchen Konfiguration wird der Laser dann bei Unterschreiten der Schwelle aktiviert. Die oben genannte Beschreibung hingegen, bei der der Laser aktiviert wird, wenn der Datenwert einen Schwellenwert überschreitet, betrifft jedoch beispielhaft den Betrag der gemessenen Tiefe im Reparaturbereich.

Die zu reparierende Bauteiloberfläche kann in der ursprünglichen Form auch gekrümmt (auch dreidimensional gekrümmt) ausgestaltet sein. Durch das erfindungsgemäße Verfahren kann somit die ursprünglich gekrümmte Oberfläche im Reparaturbereich wiederhergestellt werden. Die Messrichtung entspricht bevorzugt der Werkzeugrichtung und kann im Messzyklus bevorzugt orthogonal zur Oberfläche des Bauteils vorgesehen sein, sodass eine gesuchte Tiefe der Schadstelle ermittelt werden kann. Der Werkzeugpfad kann bevorzugt auch in einer Fläche sein welche parallel zur ursprünglichen (d.h. unversehrten) Oberfläche des Bauteils ist. Von Messpunkt zu Messpunkt kann sich somit die absolute Richtung der Messung verändern, wenn beispielsweise entlang einer gekrümmten Oberfläche gemessen wird. Diese Tiefe kann im Füllzyklus entsprechend wieder aufgefüllt werden. Die Auftragsschichten des Werkzeugs im Füllzyklus werden bevorzugt in Werkzeugrichtung aufgetragen.

## Patentansprüche

1. Verfahren zur automatisierten Reparatur von Bauteilen mit einem additiven Fertigungssystem umfassend die folgenden Schritte:
- a) Festlegen eines Reparaturbereichs (O) der die zu reparierende Fläche eines Bauteils umfasst und Festlegen eines Werkzeugpfades (PF) innerhalb des Reparaturbereichs (O);
- b) Ermitteln der Beschaffenheit des Bauteils im Reparaturbereich (O) in einem Messzyklus mittels eines Messinstruments des additiven Fertigungssystems durch Bestimmung von Datenwerten (DW) entlang des festgelegten Werkzeugpfades (PF) für die Abweichung der Fläche des Bauteils von einem vorgegebenen Abmaß; und
- c) selektives Aufbringen von Füllstoff entlang des festgelegten Werkzeugpfades (PF) mittels eines Werkzeugs des additiven Fertigungssystems in zumindest einem Füllzyklus, wobei in einem Füllzyklus ein Teil oder der gesamte Werkzeugpfad (PF) abgefahren wird und dabei selektiv das Fertigungssystem zum Aufbringen des Füllstoffs aktiviert wird, abhängig von der Differenz zwischen dem Datenwert (DW) und einem vorbestimmbaren Schwellenwert,
wobei der Werkzeugpfad (PF) dem Verfahrweg, den das Werkzeug des Fertigungssystems in zumindest einem Füllzyklus abfährt und gleichzeitig dem Verfahrweg, den das Messinstrument für die Bestimmung der Abweichung abfährt, entspricht.

2. Verfahren nach einem der vorhergehenden Ansprüche, wobei der Werkzeugpfad (PF) eine Vielzahl von Pfadpunkten (PFp) aufweist und im Schritt b) eine Abweichung an jedem der Pfadpunkte (PFp) in einer Werkzeugrichtung zwischen der Oberfläche des Bauteils und einer gewünschten Form ermittelt wird.

3. Verfahren nach einem der vorhergehenden Ansprüche, wobei die Datenwerte (DW) die Abweichung der Bauteiloberfläche in der Werkzeugrichtung angeben und die Werkzeugrichtung orthogonal zu einer gewählten Oberfläche ist, in der der Werkzeugpfad (PF) liegt.

4. Verfahren nach einem der vorhergehenden Ansprüche, wobei in einem Füllzyklus der Füllstoff entlang eines Pfadsegments (PFs) des festgelegten Werkzeugpfades (PF) selektiv aufgebracht wird, wenn der ermittelte Datenwert (DW) für das Pfadsegment (PFs) oder einem Pfadpunkt (PFp) des festgelegten Werkzeugpfads (PF) größer oder gleich einem Schwellenwert ist.

5. Verfahren nach dem vorhergehenden Anspruch, wobei ein Pfadsegment (PFs) von zwei Pfadpunkten (PFp) begrenzt wird und das Pfadsegment (PFs) bevorzugt geradlinig verläuft; und/oder wobei der Schwellenwert in einem Füllzyklus konstant ist; und/oder wobei mehrere Füllzyklen durchgeführt werden und der Schwellenwert jeweils um einen Dickenwert angepasst wird, bis eine finale Oberfläche im Reparaturbereich vorliegt welche einer Solloberfläche entspricht.

6. Verfahren nach einem der vorhergehenden Ansprüche, wobei das Ergebnis des Schritts b) ein Array bestehend aus den ermittelten Datenwerten (DW) ist und der Schwellenwert für den ersten Füllzyklus basierend auf einen Maximalwert oder Minimalwert des Arrays und/oder einer Konstanten festgelegt wird.

7. Verfahren nach einem der vorhergehenden Ansprüche, wobei der Schwellenwert in einem weiteren Füllzyklus um einen Dickenwert angepasst wird und wobei der Dickenwert der Höhe des aufgebrachten Füllstoffes in einem Füllzyklus entspricht.

8. Verfahren nach einem der vorhergehenden Ansprüche, wobei die ermittelten Datenwerte (DW) des Messzyklus direkt für den Füllzyklus verwendet werden; und/oder wobei die ermittelten Datenwerte (DW) ohne Datenkonvertierung zum Vergleich mit dem Schwellenwert im Füllzyklus verwendet werden.

9. Verfahren nach einem der vorhergehenden Ansprüche, wobei der Werkzeugpfad (PF) unter Berücksichtigung eines Arbeitsdurchmessers (WorkDia) des Fertigungsverfahrens, insbesondere eines Durchmessers eines Lasers, festgelegt wird und den gesamten Reparaturbereich (O) abdeckt; und/oder wobei der Werkzeugpfad (PF) ein nicht überlappender, durchgehender Linienzug ist der bevorzugt mäanderförmig ausgestaltet ist; und/oder wobei der festgelegte Werkzeugpfad (PF) der Verfahrweg des Werkzeugs des additiven Fertigungssystems und der Verfahrweg eines Messinstruments für die Bestimmung der Abweichung ist.

10. Verfahren nach einem der vorhergehenden Ansprüche, wobei das Werkzeug des additiven Fertigungssystems entlang des festgelegten Werkzeugpfades (PF) von einem Pfadpunkt (PFp) zu einem benachbarten Pfadpunkt (PFp) verfahren wird und an jedem Pfadpunkt (PFp) ein Vergleich des ermittelten Datenwertes (DW) des jeweiligen Pfadpunkt (PFp) und dem Schwellenwert durchgeführt wird und bei Überschreiten des Schwellenwertes das Werkzeug aktiviert wird; und/oder wobei zumindest die Schritte b) und c) vollautomatisch durchführbar sind.

11. Verfahren nach einem der vorhergehenden Ansprüche, wobei der Schritt c) umfasst: Bewegen des Werkzeugs entlang von Pfadpunkten (PFp) des festgelegten Werkzeugpfades (PF),
wobei bei Erreichen eines Pfadpunktes (PFp), an dem der Datenwert (DW) größer als der Schwellenwert ist, der Laser aktiviert (A) wird und bei Erreichen eines Pfadpunktes (PFp), an dem der Datenwert (DW) nicht größer als der Schwellenwert ist, der Laser deaktiviert (B) wird, und
wobei nach einem Füllzyklus ein weiterer Füllzyklus folgt bei dem der Schwellenwert reduziert ist.

12. Verfahren nach einem der vorhergehenden Ansprüche, wobei der festgelegte Werkzeugpfad (PF) parallele Segmente umfasst und der Abstand zwischen benachbarten Segmenten abhängig vom Arbeitsdurchmesser des Lasers festgelegt wird; und/oder wobei das additiven Fertigungssystem einen Laser umfasst und der Schritt c) umfasst: Einschalten und Ausschalten des Laser an Pfadpunkten (PFp) in Abhängigkeit vom Ergebnis des Vergleichs zwischen dem Datenwert (DW) am Pfadpunkt (PFp) und Schwellenwert; und/oder wobei zur Bestimmung der Abweichung ein Messtaster, ein optischer Sensor, ein kapazitiver Sensor, oder ein induktiver Sensor verwendet wird.

13. Additives Fertigungssystem mit einer Vorrichtung zur Datenverarbeitung umfassend Mittel zur Ausführung des Verfahrens nach Anspruch 1.

14. Computerlesbares Speichermedium, umfassend Befehle, die bei der Ausführung durch einen Computer diesen veranlassen, das Verfahren nach Anspruch 1 auszuführen.

15. Verwendung eines Additiven Fertigungssystems nach Anspruch 13, zur Reparatur von Bauteilen mittels Pulverdüsenauftragschweißen.

## Claims

1. Method for the automated repair of components using an additive manufacturing system, comprising the following steps:
- a) defining a repair region (0) which comprises the surface of a component to be repaired and defining a tool path (PF) within the repair region (0);
- b) determining the nature of the component in the repair region (0) in a measuring cycle by means of a measuring instrument of the additive manufacturing system by determining data values (DW) along the defined tool path (PF) for the deviation of the surface of the component from a predefined dimension; and
- c) selectively applying filler along the defined tool path (PF) by means of a tool of the additive manufacturing system in at least one filling cycle, wherein, in a filling cycle, part or all of the tool path (PF) is traversed and, in the process, the manufacturing system is selectively activated to apply the filler, depending on the difference between the data value (DW) and a predeterminable threshold value,
wherein the tool path (PF) corresponds to the travel path which the tool of the manufacturing system traverses in at least one filling cycle and at the same time corresponds to the travel path which the measuring instrument traverses for the determination of the deviation.

2. Method according to one of the preceding claims, wherein the tool path (PF) has a multiplicity of path points (PFp) and, in step b), a deviation is determined at each of the path points (PFp) in a tool direction between the surface of the component and a desired shape.

3. Method according to one of the preceding claims, wherein the data values (DW) specify the deviation of the component surface in the tool direction and the tool direction is orthogonal to a selected surface in which the tool path (PF) lies.

4. Method according to one of the preceding claims, wherein, in a filling cycle, the filler is selectively applied along a path segment (PFs) of the defined tool path (PF) if the determined data value (DW) for the path segment (PFs) or a path point (PFp) of the defined tool path (PF) is greater than or equal to a threshold value.

5. Method according to the preceding claim, wherein a path segment (PFs) is delimited by two path points (PFp) and the path segment (PFs) preferably runs in a straight line; and/or wherein the threshold value is constant in a filling cycle; and/or wherein a plurality of filling cycles are carried out and the threshold value is in each case adapted by a thickness value until a final surface which corresponds to a desired surface is present in the repair region.

6. Method according to one of the preceding claims, wherein the result of step b) is an array consisting of the determined data values (DW) and the threshold value for the first filling cycle is defined on the basis of a maximum value or minimum value of the array and/or a constant.

7. Method according to one of the preceding claims, wherein the threshold value is adapted by a thickness value in a further filling cycle and wherein the thickness value corresponds to the height of the applied filler in a filling cycle.

8. Method according to one of the preceding claims, wherein the determined data values (DW) of the measuring cycle are used directly for the filling cycle; and/or wherein the determined data values (DW) are used without data conversion for comparison with the threshold value in the filling cycle.

9. Method according to one of the preceding claims, wherein the tool path (PF) is defined taking into account a working diameter (WorkDia) of the manufacturing method, in particular a diameter of a laser, and covers the entire repair region (O); and/or wherein the tool path (PF) is a nonoverlapping, continuous linear profile which is preferably of meandering configuration; and/or wherein the defined tool path (PF) is the travel path of the tool of the additive manufacturing system and the travel path of a measuring instrument for the determination of the deviation.

10. Method according to one of the preceding claims, wherein the tool of the additive manufacturing system is moved along the defined tool path (PF) from one path point (PFp) to an adjacent path point (PFp) and, at each path point (PFp), a comparison of the determined data value (DW) of the respective path point (PFp) and the threshold value is carried out and, if the threshold value is exceeded, the tool is activated; and/or wherein at least steps b) and c) can be carried out fully automatically.

11. Method according to one of the preceding claims, wherein step c) comprises: moving the tool along path points (PFp) of the defined tool path (PF),
wherein, when a path point (PFp) is reached at which the data value (DW) is greater than the threshold value, the laser is activated (A) and, when a path point (PFp) is reached at which the data value (DW) is not greater than the threshold value, the laser is deactivated (B), and
wherein, after a filling cycle, a further filling cycle follows in which the threshold value is reduced.

12. Method according to one of the preceding claims, wherein the defined tool path (PF) comprises parallel segments and the distance between adjacent segments is defined depending on the working diameter of the laser; and/or wherein the additive manufacturing system comprises a laser and step c) comprises: switching the laser on and off at path points (PFp) depending on the result of the comparison between the data value (DW) at the path point (PFp) and threshold value; and/or wherein a measuring probe, an optical sensor, a capacitive sensor or an inductive sensor is used to determine the deviation.

13. Additive manufacturing system having a device for data processing, comprising means for carrying out the method according to Claim 1.

14. Computer-readable storage medium, comprising instructions which, when executed by a computer, cause the latter to carry out the method according to Claim 1.

15. Use of an additive manufacturing system according to Claim 13 for the repair of components by means of powder-jet deposition welding.

## Revendications

1. Procédé de réparation automatisée de composants avec un système de fabrication additive, comprenant les étapes suivantes :
- a) définition d'une zone de réparation (O) qui comprend la surface à réparer d'un composant et définition d'un trajet d'outil (PF) à l'intérieur de la zone de réparation (O) ;
- b) détermination de la nature du composant dans la zone de réparation (O) dans un cycle de mesure au moyen d'un instrument de mesure du système de fabrication additive par détermination de valeurs de données (DW) le long du trajet d'outil (PF) défini pour l'écart de la surface du composant par rapport à une dimension prédéfinie ; et
- c) application sélective de matière de remplissage le long du trajet d'outil (PF) défini au moyen d'un outil du système de fabrication additive dans au moins un cycle de remplissage, une partie ou la totalité du trajet d'outil (PF) étant parcourue dans un cycle de remplissage et le système de fabrication étant activé de manière sélective pour l'application de la matière de remplissage en fonction de la différence entre la valeur de données (DW) et une valeur seuil pouvant être prédéfinie,
le trajet d'outil (PF) correspondant au trajet de déplacement parcouru par l'outil du système de fabrication dans au moins un cycle de remplissage et simultanément au trajet de déplacement parcouru par l'instrument de mesure pour la détermination de l'écart.

2. Procédé selon l'une quelconque des revendications précédentes, le trajet d'outil (PF) présentant une pluralité de points de trajet (PFp) et un écart étant déterminé à l'étape b) au niveau de chacun des points de trajet (PFp) dans une direction d'outil entre la surface du composant et une forme souhaitée.

3. Procédé selon l'une quelconque des revendications précédentes, les valeurs de données (DW) indiquant l'écart de la surface du composant dans la direction d'outil et la direction d'outil étant orthogonale à une surface choisie dans laquelle se trouve le trajet d'outil (PF).

4. Procédé selon l'une quelconque des revendications précédentes, la matière de remplissage étant appliquée de manière sélective dans un cycle de remplissage le long d'un segment de trajet (PFs) du trajet d'outil (PF) défini lorsque la valeur de données (DW) déterminée pour le segment de trajet (PFs) ou un point de trajet (PFp) du trajet d'outil (PF) défini est supérieure ou égale à une valeur seuil.

5. Procédé selon la revendication précédente, un segment de trajet (PFs) étant limité par deux points de trajet (PFp) et le segment de trajet (PFs) s'étendant de préférence de manière rectiligne ; et/ou la valeur seuil étant constante dans un cycle de remplissage ; et/ou plusieurs cycles de remplissage étant réalisés et la valeur seuil étant à chaque fois adaptée d'une valeur d'épaisseur jusqu'à ce qu'une surface finale correspondant à une surface de consigne soit présente dans la zone de réparation.

6. Procédé selon l'une quelconque des revendications précédentes, le résultat de l'étape b) étant un réseau constitué des valeurs de données (DW) déterminées et la valeur seuil pour le premier cycle de remplissage étant définie sur la base d'une valeur maximale ou d'une valeur minimale du réseau et/ou d'une constante.

7. Procédé selon l'une quelconque des revendications précédentes, la valeur seuil étant adaptée d'une valeur d'épaisseur dans un autre cycle de remplissage et la valeur d'épaisseur correspondant à la hauteur de la matière de remplissage appliquée dans un cycle de remplissage.

8. Procédé selon l'une quelconque des revendications précédentes, les valeurs de données (DW) déterminées du cycle de mesure étant utilisées directement pour le cycle de remplissage ; et/ou les valeurs de données (DW) déterminées étant utilisées sans conversion de données pour la comparaison avec la valeur seuil dans le cycle de remplissage.

9. Procédé selon l'une quelconque des revendications précédentes, le trajet d'outil (PF) étant défini en tenant compte d'un diamètre de travail (WorkDia) du procédé de fabrication, en particulier d'un diamètre d'un laser, et couvrant la totalité de la zone de réparation (O) ; et/ou le trajet d'outil (PF) étant un tracé linéaire continu non chevauchant qui est de préférence réalisé en forme de méandre ; et/ou le trajet d'outil (PF) défini étant le trajet de déplacement de l'outil du système de fabrication additive et le trajet de déplacement d'un instrument de mesure pour la détermination de l'écart.

10. Procédé selon l'une quelconque des revendications précédentes, l'outil du système de fabrication additive étant déplacé le long du trajet d'outil (PF) défini d'un point de trajet (PFp) à un point de trajet (PFp) adjacent et une comparaison de la valeur de données (DW) déterminée du point de trajet (PFp) respectif et de la valeur seuil étant réalisée au niveau de chaque point de trajet (PFp) et l'outil étant activé en cas de dépassement de la valeur seuil ; et/ou au moins les étapes b) et c) pouvant être réalisées de manière entièrement automatique.

11. Procédé selon l'une quelconque des revendications précédentes, l'étape c) comprenant : le déplacement de l'outil le long de points de trajet (PFp) du trajet d'outil (PF) défini,
le laser étant activé (A) en cas d'atteinte d'un point de trajet (PFp) au niveau duquel la valeur de données (DW) est supérieure à la valeur seuil et le laser étant désactivé (B) en cas d'atteinte d'un point de trajet (PFp) au niveau duquel la valeur de données (DW) n'est pas supérieure à la valeur seuil, et
un cycle de remplissage supplémentaire étant suivi après un cycle de remplissage, au cours duquel la valeur seuil est réduite.

12. Procédé selon l'une quelconque des revendications précédentes, le trajet d'outil (PF) défini comprenant des segments parallèles et la distance entre des segments adjacents étant définie en fonction du diamètre de travail du laser ; et/ou le système de fabrication additive comprenant un laser et l'étape c) comprenant : l'activation et la désactivation du laser au niveau de points de trajet (PFp) en fonction du résultat de la comparaison entre la valeur de données (DW) au niveau du point de trajet (PFp) et la valeur seuil ; et/ou un palpeur de mesure, un capteur optique, un capteur capacitif ou un capteur inductif étant utilisé pour la détermination de l'écart.

13. Système de fabrication additive avec un dispositif de traitement de données comprenant des moyens pour la réalisation du procédé selon la revendication 1.

14. Support de stockage lisible par ordinateur, comprenant des instructions qui, lorsqu'elles sont exécutées par un ordinateur, amènent celui-ci à réaliser le procédé selon la revendication 1.

15. Utilisation d'un système de fabrication additive selon la revendication 13, pour la réparation de composants au moyen d'un soudage par apport de poudre.
